# EUROPEAN PATENT SPECIFICATION

(11) **EP 4 379 748 B1**
(45) Date of publication and mention of the grant of the patent: **19.08.2026**
(21) Application number: 22848296.4
(22) Date of filing: 15.07.2022
(51) Int. Cl.: H05K 3/14, H05K 3/46, B05B 1/32, B05B 5/16, H05K 3/12, H05K 3/04, H01B 7/08, B60R 16/02, H05K 1/02, H05K 1/05, H05K 1/09, H05K 3/00, B05B 1/02, B05B 13/04, H01B 7/02, H01B 13/012, C23C 4/129, C23C 4/131, C23C 4/134

(54) **WIRING HARNESS PRODUCTION METHOD, NOZZLE, AND WIRING HARNESS**
KABELBAUMHERSTELLUNGSVERFAHREN, DÜSE UND KABELBAUM
PROCÉDÉ DE PRODUCTION DE FAISCEAU DE CÂBLES, BUSE ET FAISCEAU DE CÂBLES

(30) Priority: 30.07.2021 CN 202110875947
(43) Date of publication of application: 05.06.2024
(73) Proprietor: Changchun Jetty Automotive Technology Co., Ltd., Changchun City, Jilin Province 130000 (CN)
(72) Inventor: WANG, Chao, Changchun, Jilin 130000 (CN)
(74) Representative: Habermann, Hruschka & Schnabel
(86) International application number: PCT/CN2022/105976
(87) International publication number: WO 2023/005691

(56) References cited:
- CN-A- 101 951 726
- CN-A- 108 738 229
- CN-A- 110 139 491
- CN-A- 113 593 776
- CN-A- 113 593 777
- CN-U- 203 932 894
- DE-B1- 2 319 997
- US-A1- 2004 251 047
- US-A1- 2006 254 051
- US-A1- 2007 298 601

## Description

### RELATED APPLICATION

The present disclosure claims priority of the Chinese invention patent with an application number of CN202110875947.7, an invention title of 'wiring harness production method, nozzle and wiring harness' and filed on July 30, 2021.

### TECHNICAL FIELD

The present disclosure relates to the technical field of electronic components, and particularly to a wiring harness production method, a nozzle and a wiring harness.

### BACKGROUND

An electrical connection needs to be realized by wiring harness. The existing wiring harness is mainly composed of parts such as electrical wires, terminals, sheaths, positioning pieces and brackets, etc. The parts are numerous, the structure is complex, and the electrical wires in the wiring harness should be produced through the processes of conductor drawing, stranding, annealing, extrusion molding of insulation layer and so on, so the production process is complex, and the processing cost is high. Most of the existing wiring harness production methods use the mode of centralized mass production.

Some wiring harness products of small batches and various product types have high requirements for flexible production and cannot be mass-produced. Such wiring harnesses can only be produced by manual works and temporary tooling, so the processing cycle is long and the production cost is increased. A method for the space-saving installation of electrical wiring is known from the prior art, for example from US20060254051A1. A method for producing multilayer conductor track structures on a substrate using a programmable tool for producing conductor tracks is known from the prior art, for example from DE2319997B1. A via structure for increased wiring on printed wiring boards is known from the prior art, for example from US20040251047A1. A method and system for controlled plating of vias are known from the prior art, for example from US20070298601A1.

### SUMMARY

An objective of the present disclosure is to provide a wiring harness production method, a nozzle and a wiring harness, so as to alleviate the technical problems of complex production process and high processing cost of a wiring harness for electrically connecting electrical components. The invention is set out in the appended set of claims. Any references to inventions or embodiments not falling within the scope of the independent claims are to be interpreted as examples useful for understanding the invention.

The above objective of the present disclosure can be achieved by the following technical solutions.

The present disclosure provides a wiring harness production method, including: Step S10: preparing a substrate; Step S20: spraying a conductive material onto the substrate to form a conductive trace; and Step S30: forming an insulating protective layer at the periphery of the conductive trace and on a surface thereof.

The present disclosure provides a nozzle, which is applied to the wiring harness production method aforementioned, and a discharge port of the nozzle is square.

The present disclosure provides a wiring harness, which is produced by the wiring harness production method aforementioned, the wiring harness including: a substrate, at least one conductive trace and at least one insulating protective layer, in which each conductive trace is located between the substrate and the outermost insulating protective layer, and the conductive trace and the insulating protective layer are alternately distributed.

The present disclosure has the following characteristics and advantages:

The wiring harness production method adopts spraying to form a conductive trace onto the substrate, in which the conductive trace may be connected to an external electrical component to realize the electrical connection function of the wiring harness; and performs an insulating protection by an insulating protective layer, thereby realizing the rapid formation of a wiring harness loop. The wiring harness production method has the following advantages:
(1) By adopting spraying to produce the wiring harness, the flexible production degree is high, the processing is fast and convenient, the efficiency is high, and the cost is far less than the existing small-batch wiring harness production mode.
(2) Multi-layer spraying can be adopted to prepare more conductive traces under the condition of a small area of the substrate, thereby meeting the demand for more electrical loops.
(3) By punching a hole and pouring a conductive material, it is possible to electrically connect the conductive traces of different layers, and realize the design scheme of a complex electrical loop, which is suitable for to more complex wiring harnesses.
(4) The cross-sectional area of the conductive trace can be adjusted by adjusting spraying parameters, which is suitable for the processing of the multi-wire diameter loop, and is convenient to control the conductivity of the conductive trace.
(5) The trajectory of the nozzle is controlled by a servo mechanism or a manipulator, which is convenient to process and realize the wiring harness with a complex spatial structure, and ensure stable spraying to keep a uniform size of the conductive trace.
(6) The material selection for the insulating protective layer is diverse, and an insulation protection can be realized by adopting a plurality of process modes to ensure the insulation protection effect.
(7) The substrate may be a constituent part of an electrical component, and can realize an integrated production of the components and the wiring harness, thereby achieving the rapid mounting and dismounting of the wiring harness.
(8) A profile modeling substrate may be adopted and spraying may be performed onto a non-planar substrate, thereby extending the application environment of the sprayed wiring harness.
(9) A flexible substrate may be adopted, so that the sprayed wiring harness can be suitable for various mounting situations. The produced wiring harness can be applied to the electrical components in complex mounting environments, and can also be used in environments with high vibration requirements to reduce the interference of vibration factors.
(10) When the wiring harness is damaged, the damaged substrate can be directly replaced without dismantling and replacing the whole wiring harness, which not only saves maintenance man-hours but also reduces the maintenance cost.
(11) A shielding structure is provided outside the wiring harness, so that a signal in the wiring harness can be shielded from electromagnetic interference at a position with strong electromagnetic interference, thereby ensuring the stability of the signal.
(12) Heat sinks are provided on the insulating protective layer to quickly dissipate heat generated by the current of the wiring harness into the air, which is beneficial to decreasing the temperature of the wiring harness and reducing the fusing risk of the conductive trace.

### BRIEF DESCRIPTION OF THE DRAWINGS

The following drawings are only for schematic illustration and explanation of the present disclosure, rather than limiting the scope thereof. In which:
FIG. 1 illustrates a schematic diagram of a wiring harness production method according to the present disclosure;
FIG. 2 illustrates a schematic working diagram of a wiring harness production method according to the present disclosure;
FIGS. 3 and 4 illustrate schematic structural diagrams of a wiring harness produced by a wiring harness production method according to the present disclosure;
FIGS. 5 and 6 illustrate schematic structural diagrams of a nozzle in a wiring harness production method according to the present disclosure;
FIG. 7 illustrates a top view of an embodiment of a wiring harness produced by a wiring harness production method according to the present disclosure;
FIG. 8 illustrates a side cross-sectional view of an embodiment of a wiring harness produced by a wiring harness production method according to the present disclosure;
FIG. 9 illustrates a top view of another embodiment of a wiring harness produced by a wiring harness production method according to the present disclosure; and
FIG. 10 illustrates a side cross-sectional view of another embodiment of a wiring harness produced by a wiring harness production method according to the present disclosure.

### DESCRIPTION OF EMBODIMENTS

In order to have a clearer understanding of the technical features, objectives and effects of the present disclosure, specific embodiments of the present disclosure will be described below with reference to the drawings. In the description of the present disclosure, unless otherwise specified, 'a plurality of' means two or more.

### Embodiment 1

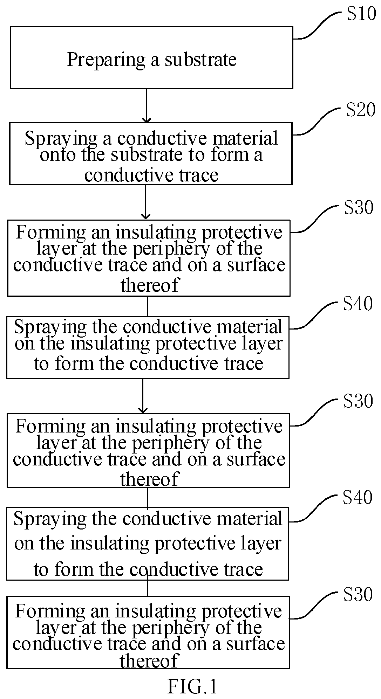

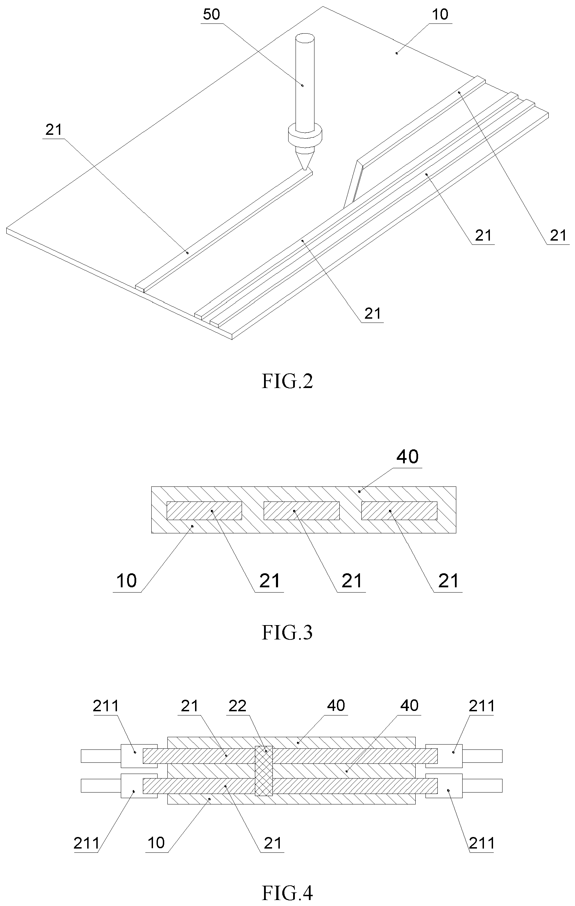

The present disclosure provides a wiring harness production method, as illustrated in FIGS. 1 and 2, including: Step S10: preparing a substrate 10; Step S20: spraying a conductive material on the substrate 10 to form a conductive trace 21; and Step S30: forming an insulating protective layer 40 at the periphery of the conductive trace 21 and on a surface thereof.

The wiring harness production method adopts spraying to form the conductive trace 21 on the substrate 10, in which the conductive trace 21 may be connected to an external electrical component to realize an electrical connection function of the wiring harness; and performs an insulating protection by the insulating protective layer 40, thereby realizing the rapid formation of a wiring harness loop. By adopting spraying to produce the wiring harness in the wiring harness production method, the flexible production degree is high, the processing is fast and convenient, the efficiency is high, the production cost is reduced, and the method is suitable for the small-batch production of wiring harnesses.

In an embodiment, the wiring harness production method includes Step S40 performed after Step S30, in which Step S40 includes spraying the conductive material onto the insulating protective layer 40 to form the conductive trace 21, and Step S40 and Step S30 are alternately performed one or more times in sequence. Step S20 forms one conductive layer 30 on the substrate 10; and when Step S40 is performed once, another conductive layer 30 may be formed on the formed conductive trace 21 and the insulating protective layer 40. By alternatively performing Step S40 and Step S30, a plurality of conductive layers 30 are constructed on the substrate 10 to form a multi-layer structure. Multi-layer spraying is adopted to form a plurality of conductive layers 30, so that more conductive traces 21 can be prepared under the condition of a small area of the substrate 10, thereby meeting the demand for more electrical loops.

FIGS. 3 and 4 illustrate schematic structural diagrams of a wiring harness produced by a wiring harness production method according to the present disclosure. The wiring harness illustrated in FIG. 3 has a single-layer structure, and the wiring harness illustrated in FIG. 4 has a double-layer structure. One conductive layer 30 may include a plurality of conductive traces 21. In a wiring harness with a multi-layer structure, each conductive layer 30 may have the same or different numbers and structures of the conductive traces 21.

Further, the wiring harness production method includes Step S50: punching a hole in the insulating protective layer 40 and/or the conductive trace 21, and pouring a conductive material to form a via 22 that electrically connects at least two layers of the conductive traces 21. By punching the hole and pouring the conductive material, it is possible to electrically connect the conductive traces 21 of different layers, and realize the design scheme of a complex electrical loop, which is suitable for more complex wiring harnesses.

In an embodiment, the wiring harness produced by the wiring harness production method includes a plurality of conductive layers 30, and a hole is punched in the insulating protective layer 40 between two adjacent conductive layers 30 and filled with a conductive material to form the via 22, which communicates the conductive traces 21 of the two adjacent conductive layers 30.

In an embodiment, the wiring harness produced by the wiring harness production method includes at least three conductive layers 30, which include an upper conductive layer 31, a middle conductive layer 32 and a lower conductive layer 33; a via 22 passing through the middle conductive layer 32 is provided to be communicated with the upper conductive layer 31 and the lower conductive layer 33, respectively. In some cases, the via 22 passes through and is communicated with the conductive trace 21 of the middle conductive layer 32, so that the upper conductive layer 31, the middle conductive layer 32 and the lower conductive layer 33 are simultaneously communicated. In other cases, the via 22 passes through the middle conductive layer 32 via an area where the conductive trace 21 is not provided, communicates the upper conductive layer 31 with the lower conductive layer 33, and bypass the conductive trace 21 of the middle conductive layer 32 to avoid a communication therewith.

In some embodiments, one or more conductive layers 30 are provided between the two conductive layers 30 which are communicated with the via 22, and a communication with the intermediate one or more conductive layers 30 should be avoided. It is possible to improve the conductive trace 21 in the intermediate one or more conductive layer 30. For example, the conductive trace 21 extends along a curve or a polyline to avoid the position where the via 22 is disposed by hole punching. It is also possible to dispose the via 22 to extend along a polyline or a curve to avoid the intermediate one or more conductive layers 30.

The hole punching and the pouring of the conductive material may be performed after each of the conductive layers 30 is formed, or at the same time of forming the conductive layer 30 and the insulating protective layer 40. For example, after one conductive layer 30 or one insulating protective layer 40 is formed, a hole is punched therein and poured with the conductive material to form the via 22, and then the next conductive layer 30 or insulating protective layer 40 is continuously formed. In some cases, the conductive traces 21 in the intermediate conductive layers 30 are dense, and it is difficult for the via 22 to bypass the conductive traces 21 in the intermediate conductive layers 30 just by improving the conductive traces 21. Therefore, the inventor makes a further improvement to the wiring harness production method and the wiring harness produced thereby.

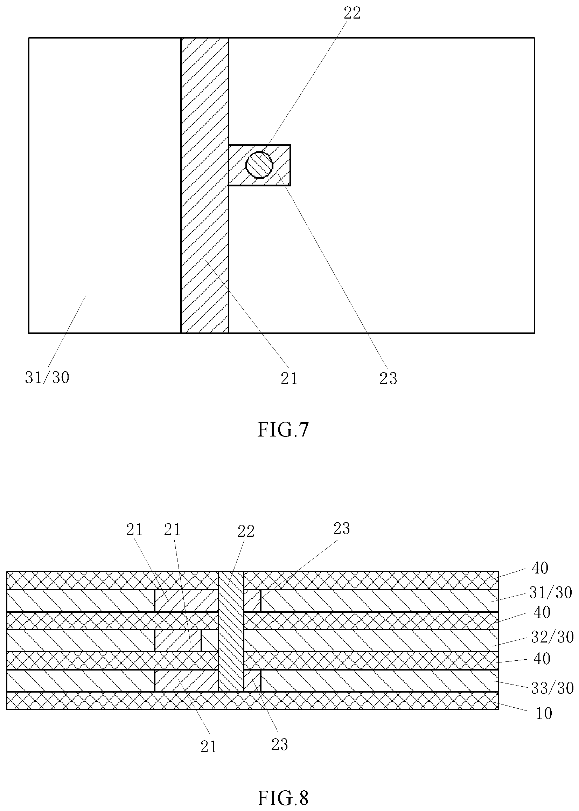

As illustrated in FIGS. 7 and 8, the wiring harness includes an upper conductive layer 31, a middle conductive layer 32 and a lower conductive layer 33; the conductive trace 21 in the upper conductive layer 31 is respectively connected to conductive protrusions 23, which are deviated from the conductive trace 21 in the middle conductive layer 32; and the via 22 is respectively communicated with the conductive protrusion 23 in the upper conductive layer 31 and the conductive protrusion 23 in the lower conductive layer 33, and bypasses the conductive trace 21 in the middle conductive layer 32, thereby communicating the upper conductive layer 31 with the lower conductive layer 33 and avoiding a communication with the middle conductive layer 32.

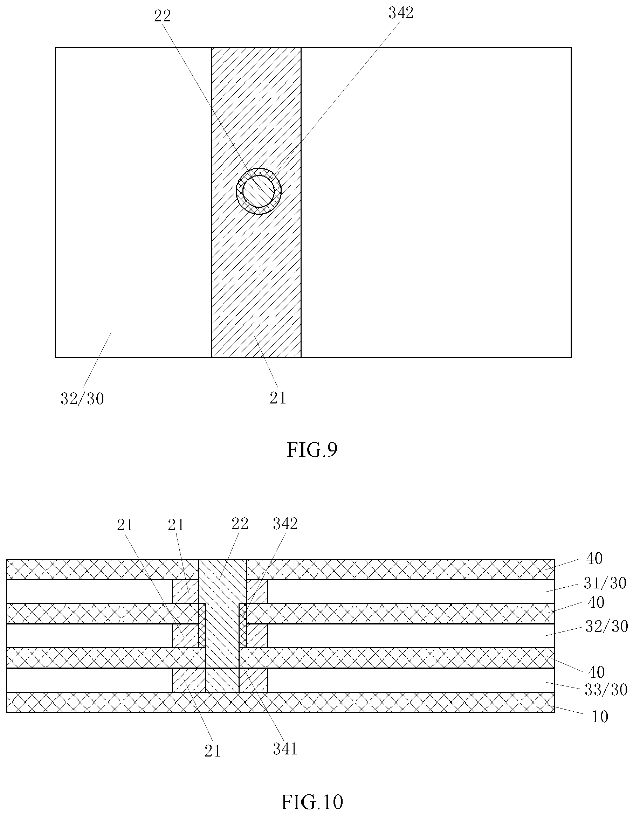

As illustrated in FIGS. 9 and 10, the wiring harness includes an upper conductive layer 31, a middle conductive layer 32 and a lower conductive layer 33; the hole punching position in Step S50 directly faces the conductive trace 21 of the upper conductive layer 31, the conductive trace 21 of the lower conductive layer 33 and the conductive trace 21 of the middle conductive layer 32; the punched hole passes through the conductive trace 21 of the middle conductive layer 32, and is provided with an insulating sleeve 342 which is located in the middle conductive layer 32 and isolates the conductive trace 21 of the middle conductive layer 32; and a conductive material is poured into the hole and the insulating sleeve 342, thereby avoiding a communication between the via 22 and the middle conductive layer 32.

Further, as illustrated in FIG. 10, the hole punched in Step S50 is a stepped hole 341, which has a part with a small inner diameter in the lower conductive layer 33 for the convenience of disposing the insulating sleeve 342, and a stepped part of the stepped hole can support the insulating sleeve 342.

The magnitude of the conduction current of the conductive trace 21 may be adjusted by adjusting a cross-sectional area of the conductive trace 21, e.g., by adjusting the thickness or the width of the conductive trace 21. In the wiring harness production method, the cross-sectional area of the conductive trace 21 may be adjusted by adjusting spraying parameters in Step S20. An appropriate thickness or width of the conductive trace 21 may be achieved according to the required magnitude of the conduction current of the conductive trace 21. The wiring harness production method is suitable for the processing of the multi-wire diameter loop, and is convenient to control the conductivity of the conductive trace 21.

In an embodiment, Step S20 and Step S40 respectively use a nozzle 50, through which the conductive material is sprayed out. By using the nozzle 50 with different sizes or shapes, a width and a thickness of the cross section of the conductive trace 21 can be adjusted.

Further, the nozzle 50 has a square discharge port 501, which is beneficial to making the width and the thickness of the cross section of the conductive trace 21 uniform, ensuring the stability of the cross section, and avoiding the situation that during spraying, there is more discharge at a middle position of the cross section and less discharge at two sides thereof and finally the conductive trace 21 is formed such that the middle of the cross section is high and the two sides thereof are low.

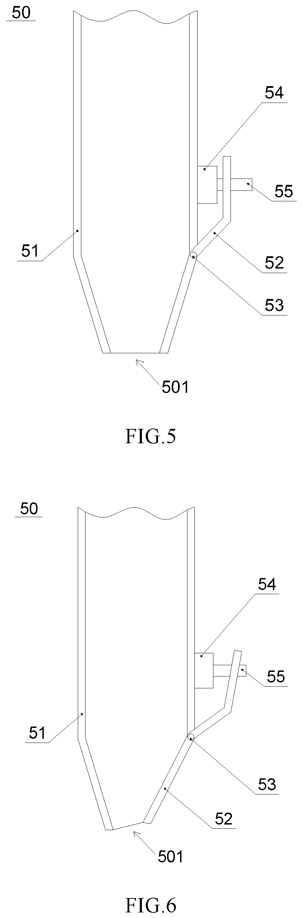

In an embodiment, the size of the discharge port 501 of the nozzle 50 is adjustable to adjust the width and the thickness of the cross section of the conductive trace 21. As illustrated in FIGS. 5 and 6, the nozzle 50 includes a nozzle body 51, and a movable sidewall 52 connected to the nozzle body 51 through a hinge 53. By rotating the movable sidewall 52 around a center of the hinge 53 relative to the nozzle body 51, a mounting angle of the movable sidewall 52 can be adjusted to adjust a position of a lower end of the movable sidewall 52, thereby adjusting the size of the discharge port 501 of the nozzle 50.

Specifically, the nozzle body 51 is connected to a motor 54, and a shaft of the motor 54 is connected to a drive screw 55; the movable sidewall 52 is provided with a threaded hole which is engaged with the drive screw 55. The motor 54 drives the drive screw 55 to rotate, and the drive screw 55 drives the movable sidewall 52 to rotate around the center of the hinge 53 to adjust the size of the discharge port 501 of the nozzle 50. The discharge port 501 of the nozzle 50 is square, which is convenient to adjust the cross-sectional area of the conductive trace 21 by adjusting the size of the discharge port 501.

The width and the thickness of the cross section of the conductive trace 21 may also be adjusted by adjusting a spraying distance of the nozzle 50, e.g., by adjusting a distance from the nozzle 50 to the substrate 10. The width and the thickness of the cross section of the conductive trace 21 may further be adjusted by adjusting a spraying speed, i.e., a moving speed of the nozzle 50. Preferably, the spraying distance is 5 mm to 100 mm and the spraying speed is 0.1 mm/s to 100 mm/s, which can prevent the spraying material from being too dispersed, and avoid the trajectory the conductive trace 21 from being fractured, thereby ensuring the conductivity.

The nozzle 50 may be mounted on a servo mechanism or a manipulator, which drives the nozzle 50 to spatially move to spray the conductive trace 21 at various angles, thereby forming a wiring harness with a spatial structure, which is convenient to process and realize a wiring harness with a complex spatial structure, and ensure stable spraying to keep a uniform size of the conductive trace 21. Further, the nozzle 50 is mounted on a three-axis servo mechanism or a six-axis manipulator.

Specifically, the three-axis servo mechanism is provided with a moving guide rail in each of directions X, Y and Z, and the movement in each direction is driven by the servo motor 54, so that a three-dimensional processing trajectory is realized under the program control, and the conductive trace 21 with a spatial trajectory is formed by spraying. The six-axis manipulator may drive the nozzle 50 to move more flexibly, thereby forming the conductive trace 21 with a more complicated spatial trajectory by spraying.

In an embodiment, one conductive layer 30 formed in Step S20 includes a plurality of conductive traces 21 to prepare more conductive traces 21. In the same conductive layer 30, the plurality of conductive traces 21 are disconnected from or electrically connected to each other. For example, the respective conductive traces 21 in the same conductive layer 30 are disconnected from each other. In the same conductive layer 30, at least two conductive traces 21 are electrically connected to each other. The conductive traces 21 in each of the conductive layers 30 are set depending on the electrical connection function to be realized.

In an embodiment, in Step S20, high-pressure airless spraying, electrostatic spraying or air spraying is adopted to spray a conductive material mixed with an adhesive onto the substrate 10. The conductive material is mixed with the adhesive and sprayed on a molding surface, and the paint is secured to form the conductive trace 21. Specifically, in the case of air spraying, compressed air is used to atomize the paint for spraying. In the case of high-pressure airless spraying, the paint is pressurized to a pressure of 9.8 MPa to 29.4 MPa by a pressurizing pump, and then sprayed through a small hole of the olive shaped nozzle 50. When rushing out of the nozzle 50 into the atmosphere, the high-pressure paint immediately expands violently and breaks into extremely fine mist, which is directly sprayed onto the surface of the substrate 10 or the formed insulating protective layer 40. In the high-pressure airless spraying, the paint is pressurized to a high pressure by the pressurizing pump and itself is not mixed with the compressed air. In the case of electrostatic spraying, the atomized paint is negatively charged under the action of a high-voltage DC electric field using a corona discharge principle, and is adsorbed on the surface of a positively charged base for discharging, in which an electrostatic spraying device includes a spray gun, a spray cup and an electrostatic spraying high-voltage power source. Exemplarily, the paint is also mixed with a solvent and an additive. The conductive material may be one or more of powders of copper, aluminum, gold, silver, graphite, etc. The adhesive includes at least one from a group consisting of epoxy resin, polyester resin, acrylic resin, polyamide resin, modified phenolic resin and cellulose resin.

In an embodiment, the conductive material includes a metallic material, and in Step S20, thermal spraying, electric arc spraying or plasma spraying is adopted to spray the molten conductive material onto the substrate 10. Specifically, in the case of thermal spraying, the paint is heated and melted, atomized into extremely fine particles by high-speed airflow, and sprayed on the molding surface at a high speed, then the paint is secured to form a coating layer. In the case of electric arc spraying, the metallic powder is continuously fed, and the arc produced by the metallic powder is utilized to melt the metal, and the molten metal is atomized by high-speed airflow, then the atomized metal particles are accelerated and sprayed on the molding surface to form the conductive trace 21. In the case of plasma spraying, the conductive material is heated to a molten or semi-molten state using a plasma electric arc driven by direct current as a heat source, and sprayed onto the molding surface at a high speed to form a firmly attached conductive trace 21. The thermal spraying includes flame spraying and electric arc spraying, and the difference therebetween only lies in whether the material is melted by a flame or an electric arc. The plasma spraying is one type of electric arc spraying, in which the plasma electric arc can produce a high temperature to heat the metallic powder. The conductive material may be a metallic powder or a metal wire.

When being a metallic powder, the conductive material includes one or combinations of nickel or alloy thereof, cadmium or alloy thereof, zirconium or alloy thereof, chromium or alloy thereof, cobalt or alloy thereof, manganese or alloy thereof, aluminum or alloy thereof, tin or alloy thereof, titanium or alloy thereof, zinc or alloy thereof, copper or alloy thereof, silver or alloy thereof, and gold or alloy thereof. When being a nonmetallic powder, the conductive material includes one or combinations of conductive ceramic, carbon-containing conductor, solid electrolyte, mixed conductor and conductive polymer material, in which the carbon-containing conductor is one or more of graphite powder, carbon nanotube material and graphene material.

Step S40 may adopt the same process method as Step S20, which is not repeated here.

In an embodiment, the insulating protective layer 40 is made of one or combinations of polyvinyl chloride, polyurethane, nylon, polypropylene, silicone rubber, crosslinked polyolefin, synthetic rubber, polyurethane elastomer, crosslinked polyethylene and polyethylene. In Step S30, one or more processes of coating, printing, spraying, immersion plating and injection molding to form the insulating protective layer 40, so as to ensure the insulating protective effect of the insulating protective layer 40 on the conductive layer 30.

Step S10 includes cleaning the surface of the substrate 10. The cleaning mode of the substrate 10 may be one or more of solution washing and cleaning, ultrasonic cleaning and high-pressure washing to remove oil stains, impurities and dirt.

In an embodiment, the wiring harness production method further includes Step S05 performed before Step S10, in which Step S05 includes: providing an insulating layer on the surface of the substrate 10, and forming the conductive trace 21 on a surface of the insulating layer. When the substrate 10 is made of a conductive material, the insulation between the conductive traces 21 can be ensured by providing an insulating layer on the substrate 10 in advance. The insulating layer may be formed by one or more processes of coating, printing, spraying, immersion plating and injection molding. When the substrate 10 is made of an insulating material, the insulating layer may not be provided.

The substrate 10 may adopt a profile modeling structure so as to facilitate the adaptation of the produced wiring harness to the application environment. The substrate 10 may adopt a flexible substrate 10, so that the produced wiring harness can be suitable for various mounting situations and convenient to be applied to electrical components in complex mounting environments, which is beneficial to reducing the interference of vibration factors and ensuring the stability of use in environments with high vibration requirements. The substrate 10 may be a constituent part of an electrical component, and can realize the integrated production of the components and the wiring harness, thereby achieving the rapid mounting and dismounting of the wiring harness. For example, the substrate 10 is a component of a vehicle body or a vehicle-mounted electrical component, and the conductive trace 21 is integrated with the substrate 10, so that the wiring harness can be replaced by replacing the substrate 10, which not only saves the maintenance man-hours, but also reduces the maintenance cost. For example, an inner lining plate of a vehicle door may be used as the substrate 10 of a door wiring harness, and the inner lining plate can be directly replaced during maintenance. The substrate 10 may also be a component of a body in white, a bumper, a roof, an inner door panel, a seat frame or any vehicle-mounted electrical component.

Under normal circumstances, the spraying process has the characteristics of large coverage, uniform thickness and strong adhesion, and is generally used in surface coating such as anti-corrosion and wear resistance. In the wiring harness production method, the conductive trace 21 is made by the spraying process, so that the width and the thickness can be adjusted and the coverage is small.

In an embodiment, the wiring harness production method includes Step S15 and Step S60, in which Step S15 is performed before Step S20 and Step S60 is performed before Step S30; Step S15 includes spraying a lower shielding layer on the substrate, and Step S60 includes spraying an upper shielding layer onto the periphery of the insulating protective layer, in which the upper shielding layer and the lower shielding layer are electrically connected to enclose the conductive trace 21.

The upper shielding layer and the lower shielding layer are connected through a shielding layer on a sidewall of the wiring harness, so that the upper shielding layer, the lower shielding layer and the shielding layer on the sidewall of the wiring harness form a box structure to surround the conductive trace 21. A shielding structure is provided outside the wiring harness, so that a signal in the wiring harness can be shielded from electromagnetic interference at a position with strong electromagnetic interference, thereby ensuring the stability of the signal.

In a case where the wiring harness includes a plurality of conductive layers, the upper shielding layer is provided above the uppermost conductive layer, that is, Step S60 is performed before Step S30 which is performed last time. Under the condition that the surface of the substrate is provided with an insulating layer, the lower shielding layer is provided above the insulating layer. The shielding layer on the sidewall of the wiring harness may be formed by spraying or printing, or formed of an aluminum foil.

In an embodiment, the wiring harness production method further includes Step S70 performed after Step S30, in which Step S70 includes crimping or welding connecting terminals at a tail end of the conductive trace 21, and by mutual plugging between the connecting terminals, achieving electrical connection between different wiring harnesses or between a wiring harness and an electrical component.

As illustrated in FIG. 4, which is not according to the invention and is present for illustration purposes only, the tail end of the conductive trace 21 is provided with a connecting terminal 211, which may be a connecting finger, a pin terminal or a welding electrical wire, so as to be connected to any other electrical loop.

Further, the wiring harness production method further includes Step S80 performed after Step S70, in which Step S80 includes providing sheaths at the tail end of the conductive trace 21, and accommodate the connecting terminals in the sheaths, so as to achieve the contact connection between the connecting terminals in the sheaths through butting between the sheaths. In some cases, a plurality of connecting terminals 211 are provided in one sheath, and two matched sheaths are connected to ensure the firmness of connection, so that the electrical connection between the connecting terminals 211 is more reliable and stable.

In an embodiment, the wiring harness production method further includes Step S90 performed after Step S30, in which Step S90 includes providing heat sinks on the insulating protective layer, and quickly dissipating the heat generated by the current of the wiring harness into the air through the heat sinks, which is beneficial to decreasing the temperature of the wiring harness and reducing the fusing risk of the conductive trace 21.

### Embodiment 2

The present disclosure provides a nozzle 50, which is applied to the wiring harness production method, and a conductive material is sprayed out through the nozzle 50. A width and a thickness of a cross section of the conductive trace 21 may be adjusted by adjusting a size or a shape of a discharge port 501 of the nozzle 50. As illustrated in FIGS. 5 and 6, the discharge port 501 of the nozzle 50 is square, which is beneficial to making the width and the thickness of the cross section of the conductive trace 21 uniform, ensuring the stability of the cross section, and avoiding the situation that during spraying, there is more discharge at a middle position of the cross section and less discharge at two sides thereof, and finally the conductive trace 21 is formed such that the middle of the cross section is high and the two sides thereof are low.

In an embodiment, the size of the discharge port 501 of the nozzle 50 is adjustable to adjust the width and the thickness of the cross section of the conductive trace 21. As illustrated in FIGS. 5 and 6, the nozzle 50 includes a nozzle body 51, and a movable sidewall 52 connected to the nozzle body 51 through a hinge 53. By rotating the movable sidewall 52 around a center of the hinge 53 relative to the nozzle body 51, a mounting angle of the movable sidewall 52 can be adjusted to adjust a position of a lower end of the movable sidewall 52, thereby adjusting the size of the discharge port 501 of the nozzle 50.

Specifically, the nozzle body 51 is connected to a motor 54, and a shaft of the motor 54 is connected to a drive screw 55; the movable sidewall 52 is provided with a threaded hole which is engaged with the drive screw 55. The motor 54 drives the drive screw 55 to rotate, and the drive screw 55 drives the movable sidewall 52 to rotate around the center of the hinge 53 to adjust the size of the discharge port 501 of the nozzle 50. The discharge port 501 of the nozzle 50 is square, which is convenient to adjust the cross-sectional area of the conductive trace 21 by adjusting the size of the discharge port 501.

### Embodiment 3

The present disclosure provides a wiring harness, which is produced by the wiring harness production method, the wiring harness including: a substrate 10, at least one conductive trace 21 and at least one insulating protective layer 40, in which each conductive trace 21 is located between the substrate 10 and the outermost insulating protective layer 40, and the conductive trace 21 and the insulating protective layer 40 are alternately distributed. The wiring harness is suitable for flexible production and small-batch production, the processing is fast and convenient, the efficiency is high, and the production cost is reduced.

In an embodiment, the conductive trace has a cross-sectional width of 0.1 mm to 68 mm. In the wiring harness, the cross-sectional area of the conductor determines the current that the conductor can conduct. In general, the conductor that realizes signal conduction has small current, so the cross-sectional area thereof is small. For example, a minimum cross-sectional area of a signal line in a vehicle wiring harness may be 0.1 mm2. But the conductor that realizes power conduction has large current, so the cross-sectional area thereof is large. For example, a maximum cross-sectional area of the wiring harness for a vehicle battery reaches 260 mm2.

When the width of the conductive trace 21 is less than 0.1 mm, in order to obtain a conductor with a cross-sectional area of 0.1 mm2, it is necessary to spray the conductive trace 21 with a thickness of at least 1 mm. Since the thickness increases as the width decreases, in order to obtain a large thickness, it is necessary to perform spraying for multiple times, which wastes the man-hours and reduces the processing efficiency. In addition, the conductive trace 21 is too narrow, the strength cannot meet the requirement, and the layout of the wiring harness is restricted, so that the height of the wiring harness cannot be reduced.

When the width of the conductive trace 21 is greater than 68 mm, in order to obtain a conductor with a cross-sectional area of 260 mm2, it is necessary to spray a conductor with a thickness of at least 3.82 mm. As the width decreases, the thickness increases, but the area of the sprayed conductive trace 21 also increases and the occupied area of the wiring harness cannot be reduced.

Therefore, the inventor chooses the cross-sectional width of the conductive trace to be 0.1 mm to 68 mm, and the conductors with different cross-sectional areas can be obtained by spraying the conductive traces 21 with different thicknesses.

Through multiple experiments, the inventor acquires that when the cross-sectional width of the conductive trace is 0.5 mm to 58 mm, an aspect ratio of the sprayed conductive trace 21 is within a reasonable range, and the thickness range is suitable for spraying and processing, while the occupied area will not be wasted. Therefore, the inventor preferably chooses the cross-sectional width of the conductive trace to be 0.5 mm to 58 mm.

In an embodiment, the conductive material includes conductive filler, adhesive, solvent and additive, and the conductive filler includes one or combinations of metallic powder, conductive ceramic, carbon-containing conductor, solid electrolyte, mixed conductor and conductive polymer material.

In an embodiment, the carbon-containing conductor is one or combinations of graphite powder, carbon nanotube material and graphene material.

In an embodiment, the metallic powder may be one or more of nickel or alloy thereof, cadmium or alloy thereof, zirconium or alloy thereof, chromium or alloy thereof, cobalt or alloy thereof, manganese or alloy thereof, aluminum or alloy thereof, tin or alloy thereof, titanium or alloy thereof, zinc or alloy thereof, copper or alloy thereof, silver or alloy thereof, and gold or alloy thereof. Exemplarily, the most commonly used metal material for the conductor is copper or copper alloy, because the conductivity of copper is good among metals, and copper is not a precious metal while being convenient for processing and good in ductility. However, with the increasing price of copper, the material cost of the conductor made of copper is higher and higher. To this end, people begin to look for alternatives to copper to reduce the cost. The content of metallic aluminum in the earth's crust is about 7.73%, and after the optimization of the refining technology, the price thereof is relatively low. In addition, compared with copper, aluminum is lighter, and its conductivity is second only to copper, so that aluminum or aluminum alloy can partially replace copper or copper alloy in the field of electrical connections.

In an embodiment, the insulating protective layer is made of one or combinations of polyvinyl chloride, polyurethane, nylon, polypropylene, silicone rubber, crosslinked polyolefin, synthetic rubber, polyurethane elastomer, crosslinked polyethylene and polyethylene.

In an embodiment, the insulating protective layer has a breakdown strength of 0.3 KV/mm to 35 KV/mm. The breakdown strength is also called a dielectric breakdown strength, which refers to a highest electric field strength that a material can withstand without being damaged (broken down) in an electric field. When the breakdown strength of the insulating protective layer is lower than 0.3 KV/mm, a thin part of the insulating protective layer may be broken down under a normal voltage, resulting in invalid insulation. When the breakdown strength of the insulating protective layer is higher than 35 KV/mm, the choice of a material with too high breakdown strength will increase the cost of an integrated wiring harness assembly and cause design waste, because a high voltage greater than 35 KV will not occur in the general vehicle-mounted environment.

In an embodiment, the insulating protective layer has a thickness of 0.03 mm to 5 mm. If the thickness of the insulating protective layer is less than 0.03 mm, not only the breakdown voltage of the insulating protective layer cannot be ensured to be higher than the working voltage, but also the wear resistance of the insulating protective layer cannot be guaranteed. After repeated scraping and grinding, the insulating protective layer may be damaged to expose the conductor, which leads to a current leakage or a short circuit, resulting in a line damage and a functional failure. When the thickness of the insulating protective layer is 5 mm, the breakdown voltage, the insulation resistance and the wear resistance of the insulating protective layer can meet the requirements. However, if the thickness is greater than 5 mm, there may be defects such as air holes and collapse during processing due to the large thickness of the insulating protective layer, which degrades the performance and wastes the material of the insulating protective layer, and increases the processing procedures and time. Therefore, the inventor chooses the thickness of the insulating protective layer as 0.03 mm to 5 mm.

The substrate 10 may adopt a profile modeling structure, so as to facilitate the adaptation of the produced wiring harness to the application environment. The substrate 10 may adopt a flexible substrate 10, so that the produced wiring harness can be suitable for various mounting situations and convenient to be applied to electrical components in complex mounting environments, which is beneficial to reducing the interference of vibration factors and ensuring the stability of use in environments with high vibration requirements. The substrate 10 may be a constituent part of an electrical component, and can realize the integrated production of the components and the wiring harness, thereby achieving the rapid mounting and dismounting of the wiring harness. For example, the substrate 10 is a component of a vehicle body or a vehicle-mounted electrical component, and the conductive trace 21 is integrated with the substrate 10, so that the wiring harness can be replaced by replacing the substrate 10, which not only saves the maintenance man-hours, but also reduces the maintenance cost. For example, an inner lining plate of a vehicle door may be used as the substrate 10 of a door wiring harness, and the inner lining plate can be directly replaced during maintenance. The substrate 10 may also be a component of a body in white, a bumper, a roof, an inner door panel, a seat frame or any vehicle-mounted component.

Generally, the printed circuit board mainly serves as a circuit board to mount electrical components and realize specific electrical functions. The wiring harness is different from the conventional printed circuit board in that the wiring harness serves to conduct current and transmit signals. The tail end of the conductive trace 21 is provided with a connecting terminal 211, which may be a connecting finger, a pin terminal, a welding electrical wire or the like so as to connect the conductive trace 21 with a power source or an electrical component.

At present, the vehicle wiring harness is generally produced separately by a wiring harness factory, where electrical wires, terminals, sheaths, positioning pieces, seals, brackets, etc. are processed and assemble together to form a complete wiring harness, and then delivered to a vehicle factory, where the wiring harness is assembled to the vehicle body depending on the working station during final assembly, so the mounting is difficult and labor is wasted.

The wiring harness may be directly mounted on a sheet metal of the vehicle body, an instrument panel or an electrical component without being disposed separately, and the mounting of the wiring harness can be completed once the mounting of vehicle components is completed, thereby saving the man-hours of the final assembly of the vehicle and reducing the manual operations by at least 60%.

Those described above are merely illustrative specific embodiments of the present disclosure, rather than limitations to the scope of the present disclosure.

## Claims

1. A wiring harness production method, comprising:
Step S10: preparing a substrate (10);
Step S20: spraying a conductive material onto the substrate (10) to form a conductive trace (21) of a lower conductive layer (33);
Step S30: forming an insulating protective layer (40) at the periphery of the conductive trace (21) and on a surface thereof; and
Step S40 performed after Step S30, wherein Step S40 comprises spraying the conductive material onto the insulating protective layer (40) to form another conductive trace (21); wherein Step S40 and Step S30 are alternately performed two or more times in sequence to obtain the conductive trace (21) of a middle conductive layer (32) and the conductive trace (21) of an upper conductive layer (31);
**characterized in that**
the wiring harness production method further comprises:
Step S50: punching a hole in the insulating protective layer (40) and the conductive traces (21) of the upper conductive layer (31), the middle conductive layer (32) and the lower conductive layer (33), disposing an insulating sleeve (342) in the portion of the hole in the middle conductive layer (32), and pouring a conductive material into the hole and the insulating sleeve (342) to form a via (22), which electrically connects the conductive trace (21) of the upper conductive layer (31) to the conductive trace (21) of the lower conductive layer (33) and is insulated from the conductive trace (21) of the middle conductive layer (32) by the insulating sleeve (342); wherein the hole punched in Step S50 is a stepped hole (341) which has a part with a small inner diameter in the lower conductive layer (33), and a stepped part of the stepped hole (341) is configured to support the insulating sleeve (342).

2. The wiring harness production method according to claim 1 further comprising:
Step S15: spraying a lower shielding layer onto the substrate (10); and
Step S60: spraying an upper shielding layer onto the periphery of the insulating protective layer (40), wherein the upper shielding layer and the lower shielding layer are electrically connected through a shielding layer on a sidewall of the wiring harness to enclose the conductive trace (21);
Step S15 is performed before Step S20, and Step S60 is performed before Step S30.

3. The wiring harness production method according to claim 1, wherein in Step S20, a nozzle (50) which has a square discharge port (501) is adopted.

4. The wiring harness production method according to claim 3, wherein the nozzle (50) is mounted on a three-axis servo mechanism or a six-axis manipulator.

5. The wiring harness production method according to claim 1, wherein in Step S20, high-pressure airless spraying, electrostatic spraying or air spraying is adopted to spray the conductive material mixed with an adhesive onto the substrate (10).

6. The wiring harness production method according to claim 1, wherein the conductive material comprises a metallic material, and in Step S20, thermal spraying, electric arc spraying or plasma spraying is adopted to spray the molten conductive material onto the substrate (10).

7. The wiring harness production method according to claim 1, wherein one conductive layer (30) formed in Step S20 comprises a plurality of the conductive traces (21) which are disconnected from or electrically connected to each other in the same conductive layer (30).

8. The wiring harness production method according to claim 1, wherein the wiring harness production method further comprising Step S05 performed before Step S10, wherein Step S05 comprises providing an insulating layer on a surface of the substrate (10).

9. The wiring harness production method according to claim 1, further comprising Step S70 performed after Step S30, wherein Step S70 comprises: crimping or welding connecting terminals (211) at a tail end of the conductive trace (21).

10. The wiring harness production method according to claim 9, further comprising Step S80 performed after Step S70, wherein Step S80 comprises providing sheaths at the tail end of the conductive trace (21), and accommodate the connecting terminals (211) in the sheaths.

11. The wiring harness production method according to claim 1, further comprising Step S90 performed after Step S30, wherein Step S90 comprises providing heat sinks on the insulating protective layer (40).

12. The wiring harness production method according to claim 1, wherein Step S30 adopts one or more processes of coating, printing, spraying, immersion plating and injection molding to form the insulating protective layer (40).

13. A wiring harness which is produced by the wiring harness production method according to any of claims 1 to 12.

14. The wiring harness according to claim 13, wherein the conductive trace (21) has a cross-sectional width of 0.1 mm to 68 mm; preferably the conductive trace (21) has a cross-sectional width of 0.5 mm to 58 mm.

15. The wiring harness according to claim 13, wherein the insulating protective layer (40) has a breakdown strength of 0.3 KV/mm to 35 KV/mm; or
the insulating protective layer (40) has a thickness of 0.03mm to 5 mm.

## Patentansprüche

1. Verfahren zur Herstellung eines Kabelbaums, aufweisend:
Schritt S10: Vorbereiten eines Substrats (10);
Schritt S20: Aufsprühen eines leitfähigen Materials auf das Substrat (10), um eine Leiterbahn (21) einer unteren leitfähigen Schicht (33) auszubilden;
Schritt S30: Ausbilden einer isolierenden Schutzschicht (40) am Rand der Leiterbahn (21) und auf einer Oberfläche derselben; und
Schritt S40, der nach Schritt S30 durchgeführt wird, wobei Schritt S40 das Aufsprühen des leitfähigen Materials auf die isolierende Schutzschicht (40) aufweist, um eine weitere Leiterbahn (21) auszubilden; wobei Schritt S40 und Schritt S30 abwechselnd zwei- oder mehrmals nacheinander durchgeführt werden, um die Leiterbahn (21) einer mittleren leitfähigen Schicht (32) und die Leiterbahn (21) einer oberen leitfähigen Schicht (31) zu erhalten;
**dadurch gekennzeichnet, dass**
das Verfahren zur Herstellung eines Kabelbaums des Weiteren aufweist:
Schritt S50: Stanzen eines Lochs in die isolierende Schutzschicht (40) und die Leiterbahnen (21) der oberen leitfähigen Schicht (31), der mittleren leitfähigen Schicht (32) und der unteren leitfähigen Schicht (33), Anbringen einer Isolierhülse (342) in dem Abschnitt des Lochs in der mittleren leitfähigen Schicht (32) sowie Einfüllen eines leitfähigen Materials in das Loch und die Isolierhülse (342), um eine Durchkontaktierung (22) zu bilden, das die Leiterbahn (21) der oberen leitfähigen Schicht (31) mit der Leiterbahn (21) der unteren leitfähigen Schicht (33) elektrisch verbindet und durch die Isolierhülse (342) von der Leiterbahn (21) der mittleren leitfähigen Schicht (32) isoliert ist; wobei das in Schritt S50 gestanzte Loch ein abgestuftes Loch (341) ist, das in der unteren leitfähigen Schicht (33) einen Abschnitt mit kleinem Innendurchmesser aufweist, und ein abgestufter Abschnitt des abgestuften Lochs (341) so ausgebildet ist, dass er die Isolierhülse (342) aufnimmt.

2. Verfahren zur Herstellung eines Kabelbaums nach Anspruch 1, das des Weiteren aufweist:
Schritt S15: Aufsprühen einer unteren Abschirmschicht auf das Substrat (10); und
Schritt S60: Aufsprühen einer oberen Abschirmschicht auf den Randbereich der isolierenden Schutzschicht (40), wobei die obere Abschirmschicht und die untere Abschirmschicht über eine Abschirmschicht an einer Seitenwand des Kabelbaums elektrisch verbunden sind, um die Leiterbahn (21) zu umschließen;
wobei Schritt S15 vor Schritt S20 durchgeführt wird, und Schritt S60 vor Schritt S30 durchgeführt wird.

3. Verfahren zur Herstellung eines Kabelbaums nach Anspruch 1, bei dem in Schritt S20 eine Düse (50) verwendet wird, die eine quadratische Austrittsöffnung (501) aufweist.

4. Verfahren zur Herstellung eines Kabelbaums nach Anspruch 3, bei dem die Düse (50) an einem dreiachsigen Servomechanismus oder einem sechsachsigen Manipulator angebracht ist.

5. Verfahren zur Herstellung eines Kabelbaums nach Anspruch 1, bei dem in Schritt S20 Hochdruck-Airless-Spritzen, elektrostatisches Spritzen oder Luftspritzen verwendet werden, um das mit einem Klebstoff vermischte leitfähige Material auf das Substrat (10) zu sprühen.

6. Verfahren zur Herstellung eines Kabelbaums nach Anspruch 1, bei dem das leitfähige Material ein metallisches Material aufweist und in Schritt S20 thermisches Spritzen, Lichtbogenspritzen oder Plasmaspritzen angewendet wird, um das geschmolzene leitfähige Material auf das Substrat (10) zu sprühen.

7. Verfahren zur Herstellung eines Kabelbaums nach Anspruch 1, bei dem eine in Schritt S20 gebildete leitfähige Schicht (30) eine Vielzahl von Leiterbahnen (21) aufweist, die innerhalb derselben leitfähigen Schicht (30) voneinander getrennt oder elektrisch miteinander verbunden sind.

8. Verfahren zur Herstellung eines Kabelbaums gemäß Anspruch 1, bei dem das Verfahren zur Herstellung eines Kabelbaums des Weiteren den Schritt S05 aufweist, der vor dem Schritt S10 durchgeführt wird, wobei der Schritt S05 das Aufbringen einer Isolierschicht auf eine Oberfläche des Substrats (10) aufweist.

9. Verfahren zur Herstellung eines Kabelbaums nach Anspruch 1, das des Weiteren den nach Schritt S30 durchgeführten Schritt S70 aufweist, wobei Schritt S70 das Crimpen oder Schweißen von Anschlussklemmen (211) an einem hinteren Ende der Leiterbahn (21) aufweist.

10. Verfahren zur Herstellung eines Kabelbaums nach Anspruch 9, das des Weiteren den nach Schritt S70 durchgeführten Schritt S80 aufweist, wobei Schritt S80 das Anbringen von Ummantelungen am hinteren Ende der Leiterbahn (21) und das Aufnehmen der Anschlussklemmen (211) in den Ummantelungen aufweist.

11. Verfahren zur Herstellung eines Kabelbaums nach Anspruch 1, das des Weiteren den nach Schritt S30 durchgeführten Schritt S90 aufweist, wobei Schritt S90 das Anbringen von Kühlkörpern auf der isolierenden Schutzschicht (40) aufweist.

12. Verfahren zur Herstellung eines Kabelbaums nach Anspruch 1, bei dem in Schritt S30 ein oder mehrere Verfahren aus Beschichten, Drucken, Sprühen, Tauchbeschichten und Spritzgießen angewendet werden, um die isolierende Schutzschicht (40) auszubilden.

13. Kabelbaum, der durch das Verfahren zur Herstellung eines Kabelbaums gemäß einem der Ansprüche 1 bis 12 hergestellt wird.

14. Kabelbaum nach Anspruch 13, bei dem die Leiterbahn (21) eine Querschnittsbreite von 0,1 mm bis 68 mm aufweist; vorzugsweise die Leiterbahn (21) eine Querschnittsbreite von 0,5 mm bis 58 mm aufweist.

15. Kabelbaum nach Anspruch 13, bei dem die isolierende Schutzschicht (40) eine Durchschlagfestigkeit von 0,3 kV/mm bis 35 kV/mm aufweist; oder
die isolierende Schutzschicht (40) eine Dicke von 0,03 mm bis 5 mm aufweist.

## Revendications

1. Procédé de fabrication d'un faisceau de câbles, comprenant:
étape S10: préparer d'un substrat (10);
étape S20: pulvériser d'un matériau conducteur sur le substrat (10) afin de former une piste conductrice (21) d'une couche conductrice inférieure (33);
étape S30: former d'une couche protectrice isolante (40) sur le bord de la piste conductrice (21) et sur une surface de celle-ci; et
étape S40, réalisée après l'étape S30, l'étape S40 consistant à pulvériser le matériau conducteur sur la couche protectrice isolante (40) afin de former une autre piste conductrice (21); les étapes S40 et S30 étant exécutées en alternance deux fois ou plus successivement afin d'obtenir la piste conductrice (21) d'une couche conductrice intermédiaire (32) et la piste conductrice (21) d'une couche conductrice supérieure (31);
**caractérisé en ce que**
le procédé de fabrication d'un faisceau de câbles comprend en outre:
l'étape S50 : poinçonner d'un trou dans la couche protectrice isolante (40) et dans les pistes conductrices (21) de la couche conductrice supérieure (31), de la couche conductrice intermédiaire (32) et de la couche conductrice inférieure (33), placer d'une douille isolant (342) dans la partie du trou située dans la couche conductrice intermédiaire (32), ainsi que remplir du trou et de la douille isolante (342) avec un matériau conducteur afin de former un trou de passage (22) qui relie électriquement la piste conductrice (21) de la couche conductrice supérieure (31) à la piste conductrice (21) de la couche conductrice inférieure (33) et qui est isolée de la piste conductrice (21) de la couche conductrice intermédiaire (32) par la douille isolante (342); le trou découpé à l'étape S50 étant un trou étagé (341) qui présente, dans la couche conductrice inférieure (33), une partie de petit diamètre intérieur, et une partie étagée du trou étagé (341) étant formée de manière à recevoir la douille isolante (342).

2. Procédé de fabrication d'un faisceau de câbles selon la revendication 1, comprenant en outre:
étape S15: pulvériser d'une couche de blindage inférieure sur le substrat (10); et
étape S60: pulvériser d'une couche de blindage supérieure sur la zone périphérique de la couche protectrice isolante (40), la couche de blindage supérieure et la couche de blindage inférieure étant reliées électriquement par l'intermédiaire d'une couche de blindage sur une paroi latérale du faisceau de câbles afin d'entourer la piste conductrice (21);
l'étape S15 étant réalisée avant l'étape S20, et l'étape S60 étant réalisée avant l'étape S30.

3. Procédé de fabrication d'un faisceau de câbles selon la revendication 1, dans lequel, à l'étape S20, on utilise une buse (50) présentant un orifice de sortie carré (501).

4. Procédé de fabrication d'un faisceau de câbles selon la revendication 3, dans lequel la buse (50) est montée sur un servomécanisme triaxial ou un manipulateur à six axes.

5. Procédé de fabrication d'un faisceau de câbles selon la revendication 1, dans lequel, à l'étape S20, on utilise la projection airless à haute pression, la projection électrostatique ou la projection à l'air pour pulvériser le matériau conducteur mélangé à un adhésif sur le substrat (10).

6. Procédé de fabrication d'un faisceau de câbles selon la revendication 1, dans lequel le matériau conducteur comprend un matériau métallique et, à l'étape S20, on utilise la projection thermique, la projection à l'arc électrique ou la projection au plasma pour projeter le matériau conducteur fondu sur le substrat (10).

7. Procédé de fabrication d'un faisceau de câbles selon la revendication 1, dans lequel une couche conductrice (30) formée à l'étape S20 comporte une pluralité de pistes conductrices (21) qui sont séparées les unes des autres ou reliées électriquement entre elles au sein de cette même couche conductrice (30).

8. Procédé de fabrication d'un faisceau de câbles selon la revendication 1, dans lequel le procédé de fabrication d'un faisceau de câbles comprend en outre l'étape S05, qui est réalisée avant l'étape S10, l'étape S05 consistant à appliquer une couche isolante sur une surface du substrat (10).

9. Procédé de fabrication d'un faisceau de câbles selon la revendication 1, qui comprend en outre l'étape S70 effectuée après l'étape S30, l'étape S70 consistant à sertir ou à souder des bornes de connexion (211) à une extrémité arrière de la piste conductrice (21).

10. Procédé de fabrication d'un faisceau de câbles selon la revendication 9, qui comprend en outre l'étape S80 effectuée après l'étape S70, l'étape S80 consistant à fixer des gaines à l'extrémité arrière de la piste conductrice (21) et à loger les bornes de connexion (211) dans les gaines.

11. Procédé de fabrication d'un faisceau de câbles selon la revendication 1, qui comprend en outre l'étape S90 effectuée après l'étape S30, l'étape S90 consistant à fixer des dissipateurs thermiques sur la couche protectrice isolante (40).

12. Procédé de fabrication d'un faisceau de câbles selon la revendication 1, dans lequel, à l'étape S30, on utilise un ou plusieurs procédés parmi le revêtement, l'impression, la pulvérisation, le revêtement par immersion et le moulage par injection pour former la couche protectrice isolante (40).

13. Faisceau de câbles fabriqué selon le procédé de fabrication d'un faisceau de câbles selon l'une des revendications 1 à 12.

14. Faisceau de câbles selon la revendication 13, dans lequel la piste conductrice (21) présente une largeur de section transversale comprise entre 0,1 mm et 68 mm; de préférence, la piste conductrice (21) présente une largeur de section transversale comprise entre 0,5 mm et 58 mm.

15. Faisceau de câbles selon la revendication 13, dans lequel la couche protectrice isolante (40) présente une rigidité diélectrique comprise entre 0,3 kV/mm et 35 kV/mm; ou
la couche protectrice isolante (40) présente une épaisseur comprise entre 0,03 mm et 5 mm.
